(19) **Europäisches Patentamt**

**European Patent Office**

**Office européen des brevets**

(11) **EP 1 001 523 A1**

(12) **EUROPÄISCHE PATENTANMELDUNG**

(43) Veröffentlichungstag:
**17.05.2000 Patentblatt 2000/20**

(51) Int. Cl.⁷: **H03D 7/16**

(21) Anmeldenummer: **99113982.5**

(22) Anmeldetag: **17.07.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **16.11.1998 DE 19852676**

(71) Anmelder: **ROBERT BOSCH GMBH**
**70442 Stuttgart (DE)**

(72) Erfinder: **Auer, Erich**
**74354 Besigheim (DE)**

(54) **Vorrichtung zur Frequenzsynchronisation in einem Nachrichtenübertragungssystem**

(57) Eine Synchronisationsvorrichtung, die einen Anstieg des Phasenrauschens im Sende- und Empfangszweig vermeidet, besteht darin, daß für die Frequenzumsetzung in den RF- und ZF-Stufen des Sende- und des Empfangszweiges freilaufende Lokaloszillatoren (LO1, LO2) vorgesehen sind, daß ein Phasendiskriminator die Frequenzablage der freilaufenden Lokaloszillatoren LO1, LO2) gegenüber einer festen Referenzfrequenz (xRef) ermittelt und daß eine Recheneinheit aus den ermittelten Frequenzablagen und vorgegebenen Umsetzungsfaktoren der einzelnen Umsetzer (UM, UZ1T, UZ2T, URT, URR, UZ2R, UZ1R, UD) für die Umsetzer des Modulators und des Demodulators korrigierte Umsetzungsfaktoren (a*, a'*) herleitet, die eine Synchronisation der Sende- und der Empfangsfrequenz (fBRT, fBRR) auf Sollwerte zur Folge haben.

**Fig. 1**

**Beschreibung**

Stand der Technik

Die vorliegende Erfindung betrifft eine Vorrichtung zur Frequenzsynchronisation in einem Nachrichtenübertragungssystem, das in seinem Sendezweig einen Modulator, ein oder mehrere ZF-Stufen und eine RF-Stufe und in seinem Empfangszweig eine RF-Stufe eine oder mehrere ZF-Stufen und einen Demodulator aufweist, wobei die ZF- und die RF-Stufen, der Modulator und der Demodulator Umsetzer enthalten, die von Lokaloszillatoren in entsprechenden Frequenzlagen angesteuert werden.

Nach diesem Prinzip sind die Sende- und Empfangszweige von Nachrichtenübertragungssystemen, seien es drahtgebundene oder Funkübertragungssysteme, üblicherweise aufgebaut. Damit es bei Nachrichtenübertragungssystemen, deren Sende- und Empfangsfrequenzbänder aus frequenzökonomischen Gründen sehr eng ohne breite Schutzbänder nebeneinanderliegen, nicht zu Interferenzen kommt, ist eine möglichst stabile Synchronisation der Sende- und Empfangsträgerfrequenzen erforderlich.

Um eine hohe Frequenzsynchronität zu erreichen, werden in bekannter Weise alle Trägerfrequenzen innerhalb eines Nachrichtenübertragungssystems mittels Phasenregelschleifen (PLL) auf ein oder mehrere stabile Referenzfrequenzen eingerastet. Es ist ein allgemein angestrebtes Ziel, das Phasenrauschen in Nachrichtenübertragungssystemen möglichst gering zu halten. Zur Verwirklichung dieses Zieles sollten zumindestens in der RF-Stufe und in den ZF-Stufen freilaufende Lokaloszillatoren eingesetzt werden, die auf ein minimales Phasenrauschen abgestimmt sind. Der Vorteil eines nur sehr geringen Phasenrauschens geht aber bei einer Frequenzregelung der Lokaloszillatoren verloren.

Der Erfindung liegt daher die Aufgabe zugrunde, eine Vorrichtung der eingangs genannten Art anzugeben, mit der sowohl ein möglichst geringes Phasenrauschen als auch eine hohe Frequenzsynchronität erreichbar ist.

Vorteile der Erfindung

Die genannte Aufgabe wird mit den Merkmalen des Anspruchs 1 dadurch gelöst, daß für die Frequenzumsetzung in den RF- und ZF-Stufen freilaufende Lokaloszillatoren vorgesehen sind, daß ein Phasendiskriminator die Frequenzablagen der freilaufenden Lokaloszillatoren gegenüber einer festen Referenzfrequenz ermittelt und daß eine Recheneinheit aus den ermittelten Frequenzablagen und vorgegebenen Umsetzungsfaktoren der einzelnen Umsetzer der ZF- und RF-Stufen für die Umsetzer des Modulators und des Demodulators korrigierte Umsetzungsfaktoren herleitet, die eine Synchronisation der Sende- und der Empfangsfrequenz auf Sollwerte zur Folge haben. Dadurch, daß für die Synchronisation ausschließlich die Lokaloszillatorfrequenzen des Modulators und des Demodulators geregelt werden, die Lokaloszillatoren in den ZF- und RF-Stufen aber freilaufend sind, verschlechtert diese Frequenzsynchronisation das Phasenrauschen im Nachrichtenübertragungssystem nicht, bewirkt aber trotzdem eine sehr exakte Synchronisation der Sende- und Empfangsfrequenzen auf vorgegebene Sollwerte.

Zweckmäßige Ausführungen der Erfindung gehen aus den Unteransprüchen hervor. Demnach synthetisiert ein direkter digitaler Synthesizer (DDS) aus den Signalen der freilaufenden Lokaloszillatoren Sinusschwingungen, die dem Phasendiskriminator zum Phasenvergleich mit der stabilen Referenzfrequenz zugeführt werden.

Es ist zweckmäßig, die Signale der einzelnen freilaufenden Lokaloszillatoren über einen einstellbaren Teiler dem direkten digitalen Synthesizer zuzuführen.

Außerdem ist es zweckmäßig, die stabile Referenzfrequenz und auch die vom direkten digitalen Synthesizer synthetisierte Sinusschwingung jeweils über einen einstellbaren Teiler dem Phasendiskriminator zuzuführen.

Zeichnung

Anhand eines in der Zeichnung dargestellten Ausführungsbeispiels wird nachfolgend die Erfindung näher erläutert. Es zeigen:

Figur 1 ein Prinzipschaltbild eines Nachrichtenübertragungssystems und
Figur 2 eine Schaltung zur Frequenzsynchronisation.

Beschreibung eines Ausführungsbeispiels

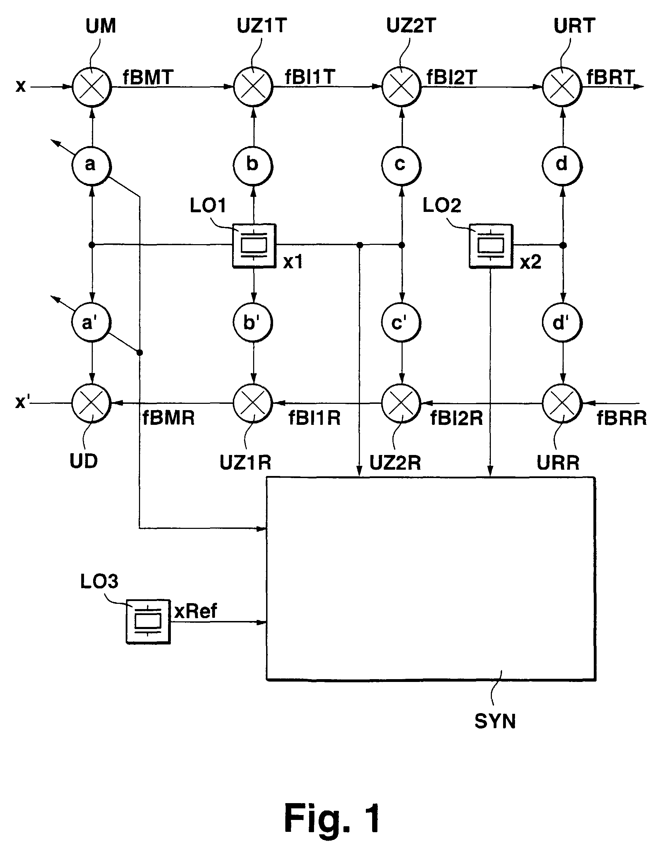

Der Figur 1 ist eine Sende-/Empfangsschaltung eines Nachrichtenübertragungssystems zu entnehmen. Da es bei der Erfindung um die Synchronisation der Sendefrequenz fBRT und der Empfangsfrequenz fBRR geht, sind in der Figur 1 ausschließlich alle die Trägerfrequenzen erzeugenden und umsetzenden Schaltungsmittel dargestellt. Von der Darstellung anderer für die Signalverarbeitung erforderlichen Schaltelemente ist abgesehen worden.

Im Sendezweig wird ein Modulationssignal x von einem Umsetzer UM einem Träger aufmoduliert, der einer mit dem Umsetzungsfaktor a multiplizierten Frequenz x1 eines ersten freilaufenden Lokaloszillators LO1 entspricht. Die aus dem Umsetzer UM hervorgehende Frequenz fBMT wird einem ersten Zwischenfrequenz-Umsetzer UZ1T zugeführt. Als Steuerfrequenz erhält dieser Umsetzer UZ1T die mit dem Umsetzungsfaktor b multiplizierte Frequenz x1 des ersten Lokaloszillators LO1.

Die Ausgangsfrequenz fBI1T des ersten ZF-Umsetzers UZ1T gelangt zu einem zweiten ZF-Umsetzer UZ2T. Dieser Umsetzer UZ2T wird von der mit einem Umsetzungsfaktor c multiplizierten Frequenz x1 des ersten Lokaloszillators LO1 angesteuert.

In einem Nachrichtenübertragungssystem kann abweichend von dem dargestellten Ausführungsbeispiel auch nur eine einzige Zwischenfrequenz (ZF)-Stufe, oder es können auch mehr als zwei ZF-Stufen vorhanden sein.

Die Ausgangsfrequenz fBI2T des zweiten ZF-Umsetzers UZ2T gelangt an den Eingang eines Hochfrequenz (RF)-Umsetzers URT. Die Steuerfrequenz für diesen RF-Umsetzer ist die mit einem Umsetzungsfaktor d beaufschlagte Frequenz x2 eines zweiten freilaufenden Lokaloszillators LO2. Am Ausgang des RF-Umsetzers URT steht die Sendefrequenz fBRT zur Verfügung.

Im Empfangszweig ist ein RF-Umsetzers URR vorhanden, dem die Empfangsfrequenz fBRR zugeführt wird. Die Steuerfrequenz für diesen RF-Umsetzer ist wiederum die von dem zweiten Lokaloszillator LO2 erzeugte, mit einem Umsetzungsfaktor d' multiplizierte Frequenz x2. Die Ausgangsfrequenz fBI2R des RF-Umsetzers URR liegt am Eingang eines ZF-Umsetzers UZ2R an. Dieser Umsetzer UZ2R wird von der mit einem Umsetzungsfaktor c' multiplizierten Frequenz x1 des ersten Lokaloszillators LO1 angesteuert. Ähnlich wie im Sendezweig ist im Empfangszweig auch ein weiterer ZF-Umsetzer UZ1R vorhanden. Dieser Umsetzer UZ1R setzt die vom vorhergehenden ZF-Umsetzer UZ2R gelieferte Frequenz fBI1R mit Hilfe der von dem ersten Lokaloszillator LO1 stammenden und einem Umsetzungsfaktor b' multiplizierten Frequenz x1 in eine Zwischenfrequenz fBMR um. Es folgt ein Umsetzer UD, der das in die Zwischenfrequenzebene fBMR heruntergesetzte Empfangssignal demoduliert. Als Steuersignal erhält der Umsetzer UD dazu die vom Lokaloszillator LO1 erzeugte und mit dem Umsetzungsfaktor a' multiplizierte Frequenz x1. Das demodulierte Empfangssignal x' liegt am Ausgang des Umsetzers UD an.

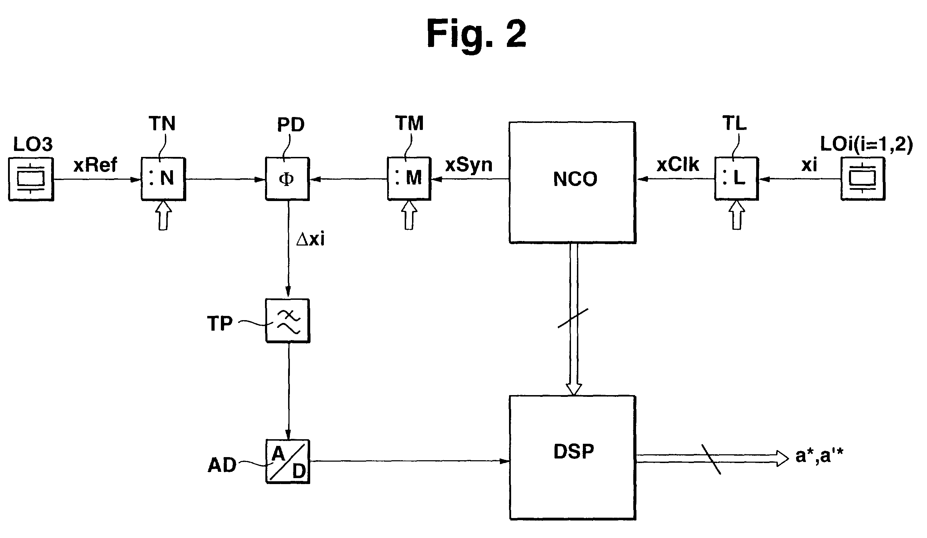

Die Sendefrequenz fBRT und die Empfangsfrequenz fBRR sollen jeweils auf einen festen Sollwert eingerastet werden. Dazu dient eine Synchronisationsschaltung SYN, der die Frequenzen x1 und x2 der beiden freischwingenden Lokaloszillatoren LO1 und LO2 und eine von einem sehr stabilen Lokaloszillator LO3 erzeugte Referenzfrequenz xRef zugeführt sind. Die Funktion dieser Synchronisationsschaltung SYN wird anhand der Figur 2 näher beschrieben.

Die in der Figur 2 dargestellte Synchronisationsschaltung SYN besitzt einen Phasendiskriminator PD, mit dem die Frequenzablagen zwischen den Lokaloszillatorfrequenzen x1 und x2 gegenüber der Referenzfrequenz xRef des stabilen Lokaloszillators LO3 erfaßt werden. Einem ersten Eingang des Phasendiskriminators PD wird dazu die Referenzfrequenz xRef des Lokaloszillators LO3 und einem zweiten Eingang wahlweise die Frequenzen x1 und x2 der beiden freilaufenden Lokaloszillatoren LO1 und LO2 zugeführt. Wie der Figur 2 zu entnehmen ist, werden die Frequenzen xi (i=1,2) der beiden Lokaloszillatoren LOi (i=1,2) nicht direkt dem Phasendiskriminator PD zugeführt, sondern ein direkter digitaler Synthesizer synthetisiert aus den beiden Frequenzen xi jeweils eine Sinusschwingung xSyn, welche dem Phasendiskriminator PD zur Bestimmung der Frequenzablage gegenüber der Referenzfrequenz xRef zugeführt wird.

Der direkte digitale Synthesizer NCO muß hier nicht näher beschrieben werden, da es sich hierbei um eine allgemein bekannte Schaltung (vgl. z.B. EP-A-0 492 588) handelt. Im wesentlichen besteht ein solcher direkter digitaler Synthesizer, der üblicherweise abgekürzt als DDS bezeichnet wird, aus einem Phasenakkumulator, einer Sinustabelle, einem Digital-Analog-Umsetzer und unter Umständen noch einem Tiefpassantialiasingfilter. Der Phasenakkumulator erhält als Taktsignal xClk die Frequenz xi des ersten bzw. zweiten Lokaloszillators LO1, LO2. In der Sinustabelle werden den einzelnen vom Phasenakkumulator gelieferten Phaseninkrementen die Amplitudenwerte einer Sinuswelle zugeordnet. Die dadurch entstehende digitale Sinuswelle wird anschließend vom Digital-Analog-Umsetzer in eine analoge Sinusschwingung umgesetzt. Das Tiefpassantialiasingfilter dient dazu, störende Spektralanteile des zeitdiskreten Signals zu entfernen und daraus ein zeitkontinuierliches Signal xSyn zu generieren.

Der DDS NCO ist in der Lage, auf sehr flexible Weise jede beliebige gewünschte Sinusschwingung zu erzeugen. Die synthetisierte Sinusschwingung xSyn wird bestimmt durch das Phaseninkrement j des Phasenakkumulators und der Taktfrequenz xClk. Angenommen, es steht eine Wortlänge von 32 Bit für das Phaseninkrement j des DDS zur Verfügung, so gilt für das Inkrement j als Integerzahl geschrieben:

$$0 \leq j \leq 2^{32}\text{-}1.$$

In der Synchronisationsschaltung sind für die Lokaloszillatorfrequenzen xi, für die synthetisierte Sinusschwingung xSyn und für die Referenzfrequenz xRef programmierbare Frequenzteiler TL, TM und TN vorhanden. Vorzugsweise lassen sich die Teilfaktoren L, M und N der Frequenzteiler über eine Schnittstelle zu einer Recheneinheit (z.B. Mikroprozessor) auf gewünschte Werte programmieren. Diese Frequenzteiler TL, TM und TN ermöglichen es, daß mit einem Phasendiskriminator PD im Zeitmultiplex die Frequenzablagen meheterer freilaufender Lokaloszillatoren LOi gegenüber Sollfrequenzen, die von der stabilen Referenzfrequenz xRef abgeleitet werden, bestimmt werden können.

Die Gleichung (1) macht deutlich, daß sich die Ist-Frequenzen xi(t) der freilaufenden Lokaloszillatoren LOi aus einer Soll-Frequenz xin und einer unerwünschten Frequenzablage $\Delta$xi(t) zusammensetzt.

$$xi(t) = xin + \Delta xi(t) \tag{1}$$

Die Frequenzablagen $\Delta$xi der Lokaloszillatorfrequenzen xi stellt der Phasendetektor PD an seinem Ausgang zur Verfügung. Nachdem diese Frequenzablagen $\Delta$xi über einen Tiefpassfilter TP geführt worden sind, werden sie nach einer Analog-Digital-Umsetzung AD einer Recheneinheit DSP, beispielsweise einem digitalen Signalprozessor oder einem Mikroprozessor, zugeführt. Diese Recheneinheit DSP ermittelt korrigierte Umsetzungsfaktoren a* und a'* für den Umsetzer UM des Modulators und den Umsetzer UD des Demodulators. Die korrigierten Umsetzungsfaktoren a* und a'* gewährleisten, daß auch bei freilaufenden Lokaloszillatoren LOi die Sendefrequenz fBRT und die Empfangsfrequenz fBRR auf vorgegebene Sollwerte einrasten.

Wie sich aus der Figur 1 ergibt, gilt für die Senderfrequenz

$$fBRT = a*x1+b*x1+c*x1+d*x2 \tag{2}$$

und für die Empfangsfrequenz

$$fBRR = a'*x1+b'*x1+c'*x1+d'*x2 \tag{3}$$

Für die korrigierten Umsetzungsfaktoren a* und a'* gilt

$$a*(t)=an+\Delta a(t) \tag{4}$$

$$a'*(t)=a'n+\Delta a'(t) \tag{5}$$

wobei an und a'n die Sollwerte für die Umsetzungsfaktoren a und a' sind und $\Delta$a(t) und $\Delta$a'(t) die Offsets der korrigierten Umsetzungsfaktoren a* und a'* gegenüber den Sollwerten an und a'n darstellen. Mit den Gleichungen (2) bis (5) ergeben sich die Istwerte der Sende- und der Empfangsfrequenz aus:

$$fBRT(t)=fBRTn+\Delta a(t)*x1(t)+(an+\Delta a(t)+b+c)*\Delta x1(t)+d*\Delta x2(t) \tag{6}$$

$$fBRR(t)=fBRRn+\Delta a'(t)*x1(t)+(a'n+\Delta a'(t)+b'+c')*\Delta x1(t)+d'*\Delta x2(t) \tag{7}$$

$$fBRTn=an*x1n+b*x1n+c*x1n+d*x2n \tag{8}$$

$$fBRRn=a'n*x1n+b'*x1n+c'*x1n+d'*x2n \tag{9}$$

wobei mit fBRTn und fBRRn die synchronisierten Sollwerte der Sende- und der Empfangsfrequenz darstellen. Unter der Bedingung, daß die Sende- und die Empfangsfrequenz synchronisiert ist, gilt:

$$fBRT(t)\equiv fBRTn \text{ für alle t} \tag{10}$$

$$fBRR(t)\equiv fBRRn \text{ für alle t} \tag{11}$$

Aus den Gleichungen (4) bis (11) ergeben sich die korrigierten Umsetzungsfaktoren a* und a'* wie folgt:

$$a*(t)=an-[(an+b+c)*\Delta x1(t)+d*\Delta x2(t)]/x1(t) \tag{12}$$

$$a'*(t)=a'n-[(a'n+b'+c')*\Delta x1(t)+d'*\Delta x2(t)]/x1 \tag{t) (13}$$

Gemäß den Gleichungen (12) und (13) berechnet die Recheneinheit DSP die korrigierten Umsetzungsfaktoren a* und a'*. Die in den beiden Gleichungen (12) und (13) vorkommenden Umsetzungsfaktoren an, b, c, d und a'n, b', c', d' sind als feststehende Größen in der Recheneinheit DSP abgespeichert. Die Frequenzablagen $\Delta$x1 und $\Delta$x2 erhält die Recheneinheit vom Phasendiskriminator PD und die Lokaloszillatorfrequenz x1 aus der aktuellen Einstellung des DDS NCO.

Während gemäß Figur 2 aus den Signalen xi der freilaufenden Lokaloszillatoren Loi mittels des DDS NCO eine Sinusschwingung synthetisiert wird, kann ebenso mit einem DDS aus der Referenzfrequenz xRef eine Sinusschwingung synthetisiert werden, welche dem Phasendiskriminator PD zum Phasenvergleich mit den Signalen xi der freilaufenden Oszillatoren LOi zugeführt wird.

Der Synchronisationsprozeß wird in vorgegebenen Zeitabständen periodisch wiederholt, wobei die Zeitabstände von der Driftdynamik der freilaufenden Oszillatoren LOi abhängt.

Die beschriebene Frequenzsynchronisationsvorrichtung kann entweder nur bei einem zu einer Nachrichtenübertragungsstrecke gehörenden Teilnemer oder auch bei allen Teilnehmern vorgesehen werden.

**Patentansprüche**

1. Vorrichtung zur Frequenzsynchronisation in einem Nachrichtenübertragungssystem, das in seinem Sendezweig einen Modulator, ein oder mehrere ZF-Stufen und eine RF-Stufe und in seinem Empfangszweig eine RF-Stufe, ein oder mehrere ZF-Stufen und einen Demodulator aufweist, wobei die ZF- und die RF-Stufen, der Modulator und der Demodulator Umsetzer (UM, UZ1T, UZ2T, URR, UZ2R, UZ1R, UD) enthalten, die von Lokaloszillatoren (LO1, LO2) in entsprechenden Frequenzlagen angesteuert werden, dadurch gekennzeichnet,

   - daß für die Frequenzumsetzung in den RF- und den ZF-Stufen freilaufende Lokaloszillatoren (LO1, LO2) vorgesehen sind,
   - daß ein Phasendiskriminator (PD) die Frequenzablagen der freilaufenden Lokaloszillatoren (LO1, LO2) gegenüber einer festen Referenzfrequenz (xRef) ermittelt
   - und daß eine Recheneinheit (DSP) aus den ermittelten Frequenzablagen ($\Delta$xi) und vorgegebenen Umset-zungsfaktoren (a, b, c, d, a', b', c', d') der einelnen Umsetzer (UM, UZ1T, UZ2T, URT, URR, UZ2R, UZ1R, UD) für die Umsetzer des Modulators und des Demodulators korrigierte Umsetzungsfaktoren (a*,a'*) herleitet, die eine Synchronisation der Sende- und der Empfangsfrequenz (fBRT, fBRR) auf Sollwerte zur Folge haben.

2. Vorrichtung nach Anspruch 1 dadurch gekennzeichnet, daß ein direkter digitaler Synthesizer (NCO) aus den Signalen (x1, x2) der freilaufenden Lokaloszillatoren (LO1, L02) bzw. der Referenzfrequenz (xRef) Sinusschwingungen (xSyn) synthetisiert, die dem Phasendiskriminator (PD) zum Phasenvergleich mit der stabilen Referenzfrequenz (xRef) bzw. mit den Signalen (x1, x2) der freilaufenden Lokaloszillatoren (LO1, LO2) zugeführt werden.

3. Vorrichtung nach Anspruch 2, dadurch gekennzeichnet, daß Signale (x1, x2) der einzelnen freilaufenden Lokaloszillatoren (LO1, LO2 ) über einen einstellbaren Teiler (TL) zum direkten digitalen Synthesizer (NCO) gelangen.

4. Vorrichtung nach Anspruch 1 oder 2 dadurch gekennzeichnet, daß die stabile Referenzfrequenz (xRef) über einen einstellbaren Teiler (TN) dem Phasendiskriminator (PD) zugeführt ist.

5. Vorrichtung nach Anspruch 2, dadurch gekennzeichnet, daß die vom direkten digitalen Synthesizer (NCO) synthetisierte Sinusschwingung über einen einstellbaren Teiler ( TM) dem Phasendiskriminator (PD) zugeführt ist.

# Fig. 1

# Fig. 2

EP 1 001 523 A1

**Europäisches Patentamt**

# EUROPÄISCHER RECHERCHENBERICHT

Nummer der Anmeldung

EP 99 11 3982

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 0 792 052 A (NIPPON ELECTRIC CO) 27. August 1997 (1997-08-27) * Spalte 3, Zeile 12 - Spalte 4, Zeile 41; Abbildung 1 * --- | 1 | H03D7/16 |
| A | GB 2 067 865 A (SONY CORP) 30. Juli 1981 (1981-07-30) * Zusammenfassung; Abbildung 1 * --- | 1 | |
| A | FR 2 194 076 A (NEO TEC ETUDE APPLIC TECH) 22. Februar 1974 (1974-02-22) * Seite 13, Zeile 28 - Seite 17, Zeile 33; Abbildung 3 * --- | 1 | |
| A | FR 2 759 220 A (SEXTANT AVIONIQUE) 7. August 1998 (1998-08-07) * Zusammenfassung; Abbildungen 1,2 * ----- | 1 | |

| RECHERCHIERTE SACHGEBIETE (Int.Cl.7) |
|---|
| H03D |

Der vorliegende Recherchenbericht wurde für alle Patentansprüche erstellt

| Recherchenort | Abschlußdatum der Recherche | Prüfer |
|---|---|---|
| DEN HAAG | 14. Februar 2000 | Peeters, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

## ANHANG ZUM EUROPÄISCHEN RECHERCHENBERICHT
## ÜBER DIE EUROPÄISCHE PATENTANMELDUNG NR.

EP 99 11 3982

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-02-2000

| Im Recherchenbericht angeführtes Patentdokument | | Datum der Veröffentlichung | Mitglied(er) der Patentfamilie | | Datum der Veröffentlichung |
|---|---|---|---|---|---|
| EP 0792052 | A | 27-08-1997 | JP | 9233143 A | 05-09-1997 |
| | | | AU | 1492197 A | 04-09-1997 |
| GB 2067865 | A | 30-07-1981 | JP | 56100527 A | 12-08-1981 |
| | | | CA | 1164530 A | 27-03-1984 |
| | | | DE | 3100557 A | 19-11-1981 |
| | | | FR | 2473818 A | 17-07-1981 |
| | | | NL | 8100109 A | 03-08-1981 |
| | | | US | 4395777 A | 26-07-1983 |
| FR 2194076 | A | 22-02-1974 | DE | 2337286 A | 14-02-1974 |
| | | | GB | 1420271 A | 07-01-1976 |
| | | | JP | 49085909 A | 17-08-1974 |
| | | | US | 3878476 A | 15-04-1975 |
| FR 2759220 | A | 07-08-1998 | EP | 0960473 A | 01-12-1999 |
| | | | WO | 9834340 A | 06-08-1998 |

EPO FORM P0461

Für nähere Einzelheiten zu diesem Anhang : siehe Amtsblatt des Europäischen Patentamts, Nr.12/82